# EUROPÄISCHE PATENTSCHRIFT

(11) **EP 1 326 729 B1**
(45) Veröffentlichungstag und Bekanntmachung des Hinweises auf die Patenterteilung: **21.04.2010**
(21) Anmeldenummer: 01972089.5
(22) Anmeldetag: 02.10.2001
(51) Int. Cl.: B23K 3/06, H05K 3/34, H01L 21/48

(54) **VORRICHTUNG ZUR APPLIKATION VON MATERIALSTÜCKEN AUF EIN WERKSTÜCK**
DEVICE FOR APPLYING PIECES OF MATERIAL TO A WORKPIECE
DISPOSITIF POUR APPLIQUER DES FRAGMENTS DE MATERIAU SUR UNE PIECE D'USINAGE

(30) Priorität: 06.10.2000 DE 10049583
(43) Veröffentlichungstag der Anmeldung: 16.07.2003
(73) Patentinhaber: Pac Tech - Packaging Technologies GmbH, 14641 Nauen (DE)
(72) Erfinder: ZAKEL, Elke, 14612 Falkensee (DE); KASULKE, Paul, 10551 Berlin (DE); UEBEL, Oliver, 10967 Berlin (DE); TITERLE, Lars, 10999 Berlin (DE)
(74) Vertreter: von Bülow, Tam
(86) Internationale Anmeldenummer: PCT/EP2001/011421
(87) Internationale Veröffentlichungsnummer: WO 2002/028589

(56) Entgegenhaltungen:
- DE-A- 19 541 996
- PATENT ABSTRACTS OF JAPAN vol. 008, no. 170 (M-315), 7. August 1984 (1984-08-07) -& JP 59 064162 A (SENJIYU KINZOKU KOGYO KK), 12. April 1984 (1984-04-12)
- PATENT ABSTRACTS OF JAPAN vol. 2000, no. 13, 5. Februar 2001 (2001-02-05) -& JP 2000 294681 A (ROHM CO LTD), 20. Oktober 2000 (2000-10-20)
- PATENT ABSTRACTS OF JAPAN vol. 1996, no. 07, 31. Juli 1996 (1996-07-31) -& JP 08 070174 A (MATSUSHITA ELECTRIC IND CO LTD), 12. März 1996 (1996-03-12)
- PATENT ABSTRACTS OF JAPAN vol. 1995, no. 11, 26. Dezember 1995 (1995-12-26) -& JP 07 202400 A (SONY CORP), 4. August 1995 (1995-08-04)

## Beschreibung

Die Erfindung bezieht sich auf eine Vorrichtung zur Applikation von Materialstücken auf ein Werkstück.

Materialstücke im Sinne der vorliegenden Erfindung können Stücke aus jeglichem Material sein, die in fester oder flüssiger Form vorliegen. Hierbei kann es sich um lötfähige Materialien, wie Gold, Kupfer, Zinn, Glas oder Kunststoff, handeln, die insbesondere als Mikromaterialstücke in Form von Lötkugeln, Glaskugeln oder Kunststoffkugeln vorliegen. Es kann sich auch um Keramikstücke handeln sowie um Bauteile, wie z.B. Miniaturschaltkreise, SMD-Bauteile oder ähnliches. Ganz allgemein kann jegliches Material mit der Erfindung appliziert werden.

Die DE 195 41 996 beschreibt eine Vorrichtung zur vereinzelten Applikation von Lotkugeln aus einem Lotkugelreservoir mit einer Applikationseinrichtung und einer Vereinzelungseinrichtung, bei der die Vereinzelungseinrichtung als Kreisfördereinrichtung ausgebildet ist. Durch taktweises Bewegen der Kreisfördereinrichtung werden Lotkugeln von dem Reservoir zu einer Kapillare gefördert und mittels Druckluft zum Ende der Kapillare, die zu diesem Zeitpunkt nahe einer Verbindungsstelle auf dem Werkstück ist. Durch Laserenergie wird die Lotkugel geschmolzen und fließt auf die Verbindungsstelle.

Die schnelle und genaue Positionierung der Kapillare und die schnelle, taktgenaue Zuführung von Lotkugeln zum Ende der Kapillare sind wesentliche Voraussetzungen für ein effektives und schnelles Arbeiten der Vorrichtung. Bei der bekannten Vorrichtung werden die Punkte, an denen Lotkugeln plaziert werden sollen, einzeln nacheinander angefahren. Dies ist naturgemäß zeitaufwendig und für eine Serienproduktion daher nicht geeignet.

Aufgabe der Erfindung ist es, die bekannte Vorrichtung dahingehend zu verbessern, daß sie schneller arbeitet und damit auch für eine Serienfertigung geeignet ist.

Diese Aufgabe wird durch die im Patentanspruch 1 angegebenen Merkmale gelöst. Vorteilhafte Ausgestaltungen und Weiterbildungen der Erfindung sind den Unteransprüchen zu entnehmen.

Das Grundprinzip der Erfindung besteht darin, mehrere Kapillare an einer einzigen Kreisfördereinrichtung anzuordnen. Für eine Massenproduktion werden die Kapillaren vorzugsweise im Muster der Lötpunkte angeordnet. Mit einem einzigen Takt können dann eine Vielzahl von Lötpunkten gesetzt werden. Eine universellere Vorrichtung erhält man damit, daß die Kapillare längs einer Linie ausgerichtet sind und Mittel vorgesehen sind, die dafür sorgen, daß nur ausgewählte Kapillaren Lotkugeln erhalten. Jede Kapillare kann bezüglich des Lötvorganges einzeln angesteuert werden, was entweder dadurch erfolgt, daß jeder Kapillare ein eigener Laser zugeordnet ist oder dadurch, daß ein Laser über Strahlumlenkeinrichtungen nacheinander den ausgewählten Kapillaren zugeführt wird.

Die einzelnen Kapillare sind in einem für die Serienproduktion üblichen Rastermaß angeordnet, so daß mit einem Takt immer eine ganze Linie von Lötpunkten gesetzt werden kann.

Im folgenden wird die Erfindung anhand eines Ausführungsbeispieles im Zusammenhang mit der Zeichnung ausführlicher erläutert. Es zeigt:
- Fig. 1: einen schematischen Querschnitt der Vorrichtung nach der Erfindung; und
- Fig. 2: eine schematische Draufsicht auf die Vorrichtung nach der Erfindung.

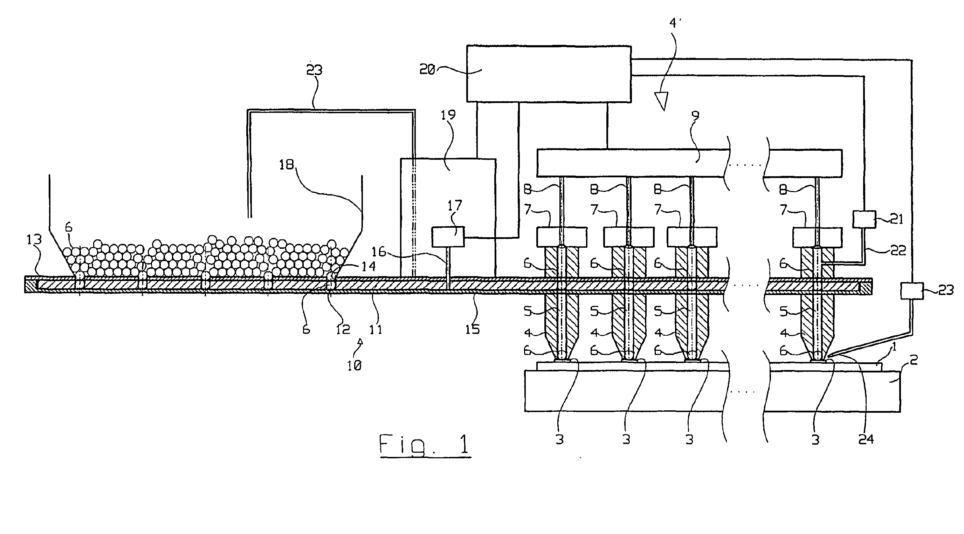

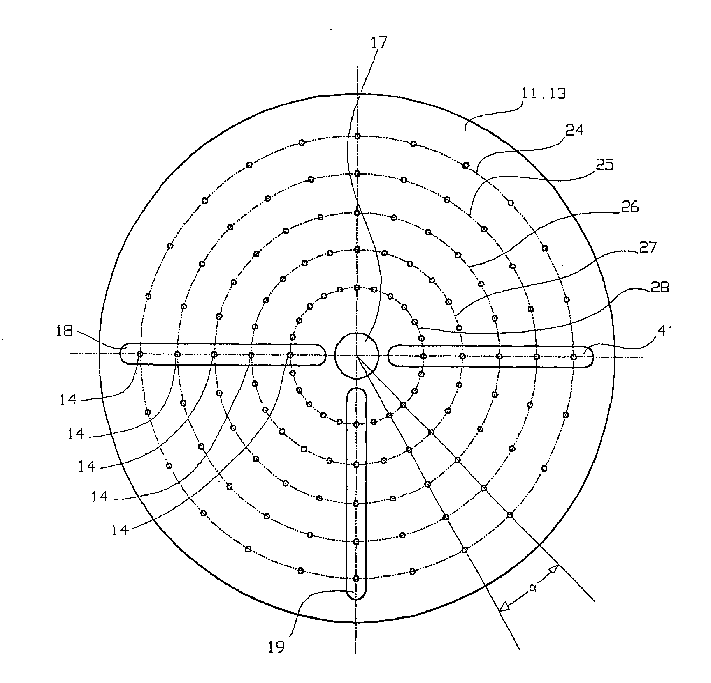

In Fig. 1 ist ein Werkstück 1 zu sehen, das auf einen Maschinentisch 2 aufgespannt ist. Am Werkstück 1 ist eine Vielzahl von Lötstellen 3. Es sei hier angenommen, daß alle Lötstellen 3 in konstantem Raster längs einer Linie liegen. Die Vorrichtung hat eine Vielzahl von Kapillaren 4, durch deren Bohrung 5 je eine Lotkugel 6 zu einer zugeordneten Lötstelle 3 gefördert wird und dort durch einen Laserstrahl aufgeschmolzen wird. Der Laserstrahl wird hier über eine Lichtleitfaser 8 und eine optische Einrichtung 7 von einer Lasereinrichtung 9 zugeführt. Jeder Kapillare kann ein eigener Laser 9 zugeordnet sein. Es ist aber auch möglich, eine einzige Laserquelle vorzusehen und über Strahlumlenkungseinrichtungen, wie z.B. einen "Beamsplitter", dann die Strahlen zu den einzelnen Kapillaren zu leiten.

Die Zufuhr von Lotkugeln 6 zu den einzelnen Kapillaren 4 erfolgt taktweise durch eine Kreisfördereinrichtung 10, die eine Kreisscheibe 11 mit einer Vielzahl von Löchern 12 aufweist, die in konzentrischen Kreisen jeweils auf einem Mittelpunktstrahl angeordnet sind, wobei der Abstand der konzentrischen Kreise 24 bis 28 in Fig. 2 dem genannten Rastermaß, d.h. dem Abstand der einzelnen Kapillaren zueinander entspricht.

Die Kreisscheibe 11 ist zwischen zwei Scheiben 13 und 15 drehbar gelagert und kann über eine Welle 16 sowie einen Motor 17 gedreht werden. Die obere Scheibe 13 besitzt im Bereich einer Füllstation ebenfalls eine Vielzahl von Löchern 14, die mit den Löchern 12 ausgerichtet sind, so daß aus der Füllstation 18 jeweils genau eine Lotkugel 6 durch die Löcher 14 hindurch in die Löcher 12 der drehbaren Kreisscheibe 11 fallen und von dort in Drehrichtung abtransportiert werden können. Pro Arbeitstakt wird die Kreisscheibe 11 um ein vorgegebenes Winkelmaß gedreht. Hierdurch werden die in der drehbaren Kreisscheibe 11 zwischengespeicherten Lotkugeln 6 dann zu den Kapillaren 4 gefördert, wo sie durch Löcher in der unteren Scheibe 15 durch die Bohrung 5 hindurch zur Spitze der Kapillare fallen und dort auf die entsprechende Lötstelle 3. Die letztere Bewegung kann durch Druckluft unterstützt werden, die von einem Drucklufterzeuger 21 über eine Rohrleitung 22 in die Bohrung 5 geleitet wird und zwar in einen Abschnitt oberhalb der oberen Kreisscheibe 13. Statt Druckluft kann natürlich auch ein Schutzgas verwendet werden. Aus Gründen der Klarheit ist in Fig. 1 nur ein Drucklufterzeuger 21 dargestellt. Selbstverständlich hat jede Kapillare einen Anschluß 22 zu dem Druckerzeuger 21.

Aus der bisherigen Beschreibung ist zu erkennen, daß die Vorrichtung pro Arbeitstakt eine beliebige Vielzahl von Lotkugeln zu einer entsprechenden Anzahl von Lötstellen fördern kann.

Für eine individuelle Applikation in Großserienfertigung wird man zweckmäßigerweise die Kapillaren von vorn herein schon so ausrichten, wie die einzelnen Lötstellen auf dem Werkstück angeordnet sind. Die Vorrichtung wird jedoch universeller, wenn die Kapillaren im Rastermaß angeordnet sind und individuell mit Lotkugeln beschickt und individuell angesteuert werden können. Dies erfolgt nach der Erfindung durch eine Absaugstation 19, die im Förderweg zwischen der Füllstation 18 und der Lötstation 4' angeordnet ist. Dort können dann selektiv durch einzelne Spuren bzw. Kreisbahnen 24, 25, 26, 27 oder 28 die in der jeweiligen Öffnung 12 vorhandene Lotkugel 6 abgesaugt werden und ggf. zurück in die Füllstation befördert werden, wie durch die Leitung 23 angedeutet. Somit kann selektiv einzelnen Kapillaren 5 keine Lötkugel zugeführt werden und die Kapillare wird für einen Lötvorgang, bei dem die übrigen Kapillaren aktiv sind, unwirksam geschaltet.

Alle Vorgänge werden von einer zentralen Steuereinheit gesteuert, also das taktweise Drehen der Kreisfördereinrichtung 10, das selektive Absaugen einzelner Lotkugeln an der Absaugstation 19, das Aktivieren des Drucklufterzeugers 21 und das Aktivieren des Lasers 9.

Im Ausführungsbeispiel der Fig. 2 ist eine große Anzahl von Löchern 12, 14 in den Scheiben 11, 13 vorgesehen. Pro Arbeitstakt wird die Kreisscheibe 11 dann nur um den Winkel α bewegt. Dies setzt selbstverständlich voraus, daß an der Absaugstation 19 eine entsprechende Anzahl von Takten vorher die entsprechende Lotkugel abgesaugt wird, bevor das entsprechende Loch die Lötstation 4' erreicht hat. Natürlich ist es auch möglich, eine geringere Anzahl von Löchern vorzusehen, was dann pro Takt eine etwas längere Drehbewegung bedingt.

## Patentansprüche

1. Vorrichtung umfassend eine Füllstation, eine Fördereinrichtung und ein Bearbeitungsstation zur Applikation von Materialstücken auf ein Werkstück mit einer Bearbeitungsstation und einer Fördereinrichtung, die Materialstücke von einer Füllstation vereinzelt und zu der Bearbeitungsstation fördert, **dadurch gekennzeichnet,**
**daß** die Bearbeitungsstation (4') eine Anzahl von Kapillaren (4) aufweist, die in vorgegebenem Muster zueinander angeordnet sind,
**daß** die Fördereinrichtung (10) an der Füllstation (18) eine gleiche Anzahl von Materialstücken (6) vereinzelt und zu den Kapillaren (4) fördert und
**daß** die Vorrichtung eine im Förderweg von der Füllstation (18) zur Bearbeitungsstation (4') angeordnete Entnahmestation (19) umfasst, die selektiv Materialstücke der Fördereinrichtung entnimmt.

2. Vorrichtung nach Anspruch 1, **dadurch gekennzeichnet, daß** die Entnahmestation eine Absaugstation (19) ist.

3. Vorrichtung nach Anspruch 1 oder 2, **dadurch gekennzeichnet,**
**daß** an der Entnahmestation (19) entnommene Lotkugeln (6) durch eine Rückführeinrichtung (23) zur Füllstation (18) rückgeführt werden.

4. Vorrichtung nach einem der Ansprüche 1 bis 3, **dadurch gekennzeichnet,**
**daß** die Kapillaren (4) längs einer geraden Linie angeordnet sind.

5. Vorrichtung nach einem der Ansprüche 1 bis 3, **dadurch gekennzeichnet,**
**daß** die Kapillaren (4) in einem Muster entsprechend einem zweidimensionalen Raster angeordnet sind.

6. Vorrichtung nach einem der Ansprüche 1 bis 3, **dadurch gekennzeichnet,**
**daß** die Kapillaren (4) in einem dreidimensionalen Raster angeordnet sind, welches durch unterschiedliche Längen der Kapillaren erreicht wird.

7. Vorrichtung nach Anspruch 5 und 6, **dadurch gekennzeichnet,**
**daß** die Kapillaren (5) in konstantem Abstand zueinander angeordnet sind, wobei dieser Abstand einem Rastermaß von Lötstellen (3) auf einem Werkstück (1) entspricht.

8. Vorrichtung nach einem der Ansprüche 1 bis 7, **dadurch gekennzeichnet,**
**daß** die Materialstücke schmelzbares Material, wie Lötmaterial, insbesondere Gold, Kupfer, Zinn, Glas oder Kunststoff sind, die in fester oder flüssiger Form vorliegen oder Keramikstücke, wobei die Materialstücke insbesondere kugelförmig sind.

9. Vorrichtung nach einem der Ansprüche 1 bis 8, **gekennzeichnet durch** eine optische oder pneumatische Einrichtung (9), die die Anwesenheit/Abwesenheit von Materialstücken in der Kapillare (4) überprüft.

10. Vorrichtung nach einem der Ansprüche 1 bis 9, **dadurch gekennzeichnet,**
**daß** jeder Kapillare (4) ein Laser (9) oder ein mit einem Laser gekoppeltes optisches System (8) zugeordnet ist.

11. Vorrichtung nach einem der Ansprüche 1 bis 10, **gekennzeichnet durch** eine Druckgasquelle (21) und eine Rohrleitung (22), die den Kapillaren (4) ein Inertgas zuführt.

12. Vorrichtung nach einem der Ansprüche 1 bis 10, **gekennzeichnet durch** eine Druckgasquelle (23), die **durch** eine von der Kapillare unabhängige Düse (24) Inertgas der Arbeitsstation (4') zuführt.

## Claims

1. Device comprising a filling station, a conveyor device and a processing station for applying pieces of material to a workpiece having a processing station and a conveyor device, which singularizes the pieces of material of a filling station and conveys it to the processing station,
**characterized in that**
the processing station (4') comprises a number of capillaries (4) arranged with respect to each other in a preset pattern,
**in that** the conveyor device (10) at the filling station (18) is singularizing the same number of pieces of material (6) and is conveying them to the capillaries (4) and
**in that** the device comprises an extraction station (19) being arranged in the conveyance path from the filling station (18) to the processing station (4'), which selectively extracts pieces of material.

2. Device according to claim 1, **characterized in that** the extraction station is a suction station (19).

3. Device according to claim 1 or 2, **characterized in that** soldering balls (6) taken from the extraction station (19) are fed back by a backfeeding device (23) to the filling station (18).

4. Device according to one of claims 1 to 3, **characterized in that** the capillaries (4) are arranged along a straight line.

5. Device according to one of claims 1 to 3, **characterized in that** the capillaries (4) are arranged in a pattern corresponding to a two-dimensional grid.

6. Device according to one of claims 1 to 3, **characterized in that** the capillaries (4) are arranged in a three-dimensional grid, which is achieved by different lengths of the capillaries.

7. Device according to claim 5 and 6, **characterized in that** the capillaries (5) are arranged at constant interval away from each other, this interval corresponding to a grid of soldering points (3) on a workpiece (1).

8. Device according to one of claims 1 to 7, **characterized in that** the pieces of material are meltable material, like solderable material, in particular gold, copper, tin, glass or plastic, which are in solid or liquid form, or pieces of ceramic, the pieces of material being globular in particular.

9. Device according to one of claims 1 to 8, **characterized by** an optical or pneumatical device (9), which detects the absence/presence of pieces of material in the capillary (4).

10. Device according to one of claims 1 to 9, **characterized in that** each capillary (4) has an assigned laser (9) or an optical system (8) coupled with a laser.

11. Device according to one of claims 1 to 10,
**characterized by** a compressed gas source (21) and a pipeline (22), which feeds an inert gas to the capillaries (4).

12. Device according to one of claims 1 to 10,
**characterized by** a compressed gas source (23), which feeds inert gas to the work station (4') through a nozzle (24), which is independent of the capillary.

## Revendications

1. Dispositif comportant une station de remplissage, un dispositif de transport et une station de traitement, destiné à l'application de fragments de matériau sur une pièce à travailler, comportant une station de traitement et un dispositif de transport, lequel isole les fragments de matériau depuis une station de remplissage et les transporte vers la station de traitement, **caractérisé en ce**
**que** la station de traitement (4') présente un certain nombre de tubes capillaires (4), lesquels sont disposés les uns par rapport aux autres selon un modèle prédéfini,
**que** le dispositif de transport (10) isole au niveau de la station de remplissage (18) un nombre identique de fragments de matériau (6) et les conduit jusqu'aux tubes capillaires (4), et en ce
**que** le dispositif comporte une station de retrait (19) disposée sur le trajet de transport allant de la station de remplissage (18) à la station de traitement (4'), laquelle station de retrait retire de manière sélective des fragments de matériau hors du dispositif de transport.

2. Dispositif selon la revendication 1, **caractérisé en ce que** la station de retrait est une station d'aspiration (19).

3. Dispositif selon la revendication 1 ou 2, **caractérisé en ce**
**que** des billes de matière de brasage (6) retirées au niveau de la station de retrait (19) sont reconduites par un dispositif de retour (23) en direction de la station de remplissage (18).

4. Dispositif selon l'une quelconque des revendications 1 à 3, **caractérisé en ce**
**que** les tubes capillaires (4) sont disposés le long d'une ligne droite.

5. Dispositif selon l'une quelconque des revendications 1 à 3, **caractérisé en ce**
**que** les tubes capillaires (4) sont disposés selon un modèle correspondant à un réseau à deux dimensions.

6. Dispositif selon l'une quelconque des revendications 1 à 3, **caractérisé en ce**
**que** les tubes capillaires (4) sont disposés selon un réseau à trois dimensions, lequel est atteint grâce à diverses longueurs de tubes capillaires.

7. Dispositif selon la revendication 5 et 6, **caractérisé en ce**
**que** les tubes capillaires (5) sont disposés à distance constante les uns des autres, cette distance correspondant à la dimension de trame de brasures (3) sur une pièce à travailler (1).

8. Dispositif selon l'une quelconque des revendications 1 à 7, **caractérisé en ce**
**que** les fragments de matériau sont en matériau fusible, tel qu'un matériau à souder, notamment en or, en cuivre, en zinc, en verre ou en matière plastique, et sont présents sous forme solide ou liquide, ou bien sont des fragments de céramique, les fragments de matériau étant notamment sous forme de bille.

9. Dispositif selon l'une quelconque des revendications 1 à 8, **caractérisé par** un dispositif (9) optique ou pneumatique, lequel contrôle la présence/ l'absence de fragments de matériau dans les tubes capillaires (4).

10. Dispositif selon l'une quelconque des revendications 1 à 9, **caractérisé en ce**
**qu'**un laser (9) ou un système (8) optique couplé à un laser est associé à chaque tube capillaire (4).

11. Dispositif selon l'une quelconque des revendications 1 à 10, **caractérisé par** une source de gaz sous pression (21) et une conduite tubulaire (22), qui conduit un gaz inerte aux tubes capillaires (4).

12. Dispositif selon l'une quelconque des revendications 1 à 10, **caractérisé par** une source de gaz sous pression (23) qui conduit du gaz inerte à la station de travail (4') grâce à une buse (24) indépendante des tubes capillaires.
